Europäisches Patentamt

European Patent Office

Office européen des brevets

(19)

(11) Veröffentlichungsnummer: **0 413 296 A1**

## (12) EUROPÄISCHE PATENTANMELDUNG

(21) Anmeldenummer: 90115548.1

(22) Anmeldetag: 14.08.90

(51) Int. Cl.⁵: **C23C 4/10**, H01L 39/24

(30) Priorität: 17.08.89 DE 3927168

(43) Veröffentlichungstag der Anmeldung:
20.02.91 Patentblatt 91/08

(84) Benannte Vertragsstaaten:
BE DE DK ES FR GB GR IT LU NL

(71) Anmelder: HOECHST AKTIENGESELLSCHAFT
Postfach 80 03 20
D-6230 Frankfurt am Main 80(DE)

(72) Erfinder: Morach, Eugen

Höhenweg 6
D-6237 Liederbach(DE)
Erfinder: Schindler, Hubert
Ahornweg 10
D-6237 Liederbach(DE)
Erfinder: Schwarz, Martin, Dr.
Bresslauer Strasse 57
D-6233 Kelkheim/Taunus(DE)
Erfinder: Dierks, Sabine
Ritterwiesen 8
D-6237 Liederbach(DE)

(54) **Verfahren zum thermischen Spritzen von oxidkeramischen supraleitenden Materialien.**

(57) Die Erfindung betrifft ein Verfahren zum thermischen Spritzen von oxidkeramischen Materialien mit einer Bruttozusammensetzung, die der eines oxidkeramischen Supraleiters entspricht. Das pulverförmige Material wird in die Heizflamme des Brenners gefördert, in der es an-bzw. aufgeschmolzen wird, und trifft als Spritzstrahl auf ein Trägermaterial. In die Heizflamme und/oder den Spritzstrahl wird zusätzlich Sauerstoff, Distickstoffoxid oder Ozon eingeleitet, um das Material, das beim thermische Spritzen Sauerstoff verliert, wieder mit Sauerstoff anzureichern. Diese Maßnahme macht eine sonst nötige thermische Nachbehandlung in Sauerstoffatmospähre überflüssig.

Fig. 1

EP 0 413 296 A1

# VERFAHREN ZUM THERMISCHEN SPRITZEN VON OXIDKERAMISCHEN SUPRALEITENDEN MATERIALIEN

Die Erfindung betrifft ein Verfahren zum thermischen Spritzen von oxidkeramischen Materialien mit einer Bruttozusammensetzung, die der eines oxidkeramischen Supraleiters entspricht, bei dem man das pulverförmige Material in die Heizflamme eines Brenners fördert, in der es an- bzw. aufgeschmolzen wird, und es als Spritzstrahl auf ein Trägermaterial auftreffen läßt.

Bei oxidkeramischen supraleitenden Materialien wird unter anderem als Formgebungsverfahren das thermische Spritzen angewandt. Beim thermischen Spritzen verlieren die Materialien ihre supraleitenden Eigenschaften, oder die supraleitenden Eigenschaften gehen zwar nicht verloren, verschlechtern sich aber deutlich. Daher ist nach dem Spritzvorgang eine thermische Nachbehandlung der abgeschiedenen Spritzschicht notwendig, um die supraleitenden Eigenschaften der Spritzschicht zu erzeugen oder zu verbessern.

Bei der thermischen Nachbehandlung wird die Spritzschicht in Sauerstoffatmosphäre bis zu einer Temperatur aufgeheizt, bei der Sauerstoff aufgenommen wird, und danach in Sauerstoffatmosphäre langsam abgekühlt. Die thermische Nachbehandlung kann dabei aus mehreren Aufheiz- und Abkühlschritten bestehen. Sie ist zeitaufwendig und kostenintensiv. Außerdam kann die thermische Nachbehandlung zu unerwünschten Verunreinigungen in der Spritzschicht führen, wenn Stoffe aus dem Trägermaterial in die Spritzschicht diffundieren oder mit der Spritzschicht chemisch reagieren.

Aufgabe der vorliegenden Erfindung ist es, ein Verfahren der eingangs genannten Art zu schaffen, bei dem eine oxidkeramische Spritzschicht auf dem Trägermaterial ge bildet wird, die bereits ohne thermische Nachbehandlung supraleitend ist bzw. gute supraleitende Eigenschaften hat.

Diese Aufgabe wird durch das in Patentanspruch 1 angegebene Verfahren gelöst.

Es ist gefunden worden, daß der Sauerstoffgehalt der hergestellten Spritzschichten in erster Linie von der während des Spritzvorgangs angebotenen Sauerstoffmenge abhängt. In normaler Luft gespritzte Schichten von $Bi_2Sr_2CaCu_2O_x$ weisen elementaranalytisch einen geringeren Sauerstoffgehalt ($Bi_2Sr_2CaCu_2O_{7,8}$) und schlechtere supraleitende Eigenschaften ($T_c$ = 80 K) auf als bei der erfindungsgemäßen Zuführung von zusätzlichem Sauerstoff ($Bi_2Sr_2CaCu_2O_{8,4}$;$T_c$ = 84 K). Entsprechendes gilt bei anderen oxidkeramischen supraleitenden Materialien, wie z.B. $YBa_2Cu_3O_x$. Die Sauerstoffanreicherung wird beim erfindungsgemäßen Verfahren einfacher, schneller und über den Querschnitt der supraleitenden Schicht gleichmäßiger erreicht als beim herkömmlichen thermischen Spritzen ohne zusätliche Sauerstoff-, Distickstoffoxidoder Ozonzufuhr und mit anschließender thermischer Nachbehandlung. Das Distickstoffoxid zersetzt sich unter den Bedingungen des thermischen Spritzens zu atomarem, hochreaktivem Sauerstoff und Stickoxiden.

Beim erfindungsgemäßen Verfahren können alle oxidkeramischen Materialien eingesetzt werden, die beim Erhitzen unter den Bedingungen des thermischen Spritzens Sauerstoff verlieren und reversibel wieder Sauerstoff aufnehmen können, z.B. $MBa_2Cu_3O_{7-x}$, wobei M Yttrium oder Seltenerdmetalle außer Ce, Pr und Nd bedeutet mit $0 \leq x \leq 1$, Bi-Sr-Ca-Cu-O, wie z.B. $Bi_2(Sr,Ca)_2CuO_x$, $Bi_2(Sr,Ca)_3Cu_2O_x$ und $Bi_2(Sr,Ca)_4$ $Cu_3O_x$, und Tl-Ba-Ca-Cu-O. Die erfindungsgemäß eingesetzten oxidkeramischen Materialien können eine Bruttozusammensetzung haben, die der eines oxidkeramischen Supraleiters entspricht, oder sie können infolge eines Sauerstoffdefizits nicht supraleitend sein aber im übrigen die Bruttzusammensetzung eines oxidkeramischen Supraleiters aufweisen. Bevorzugt werden beim erfindungsgemäßen Verfahren oxidkeramische Materialien eingesetzt, die Kupfer und Yttrium in oxidischer Form enthalten oder die Kupfer, Wismut, Strontium und Calcium in oxidischer Form enthalten.

Von den thermischen Spritzverfahren wird beim erfindungsgemäßen Verfahren insbesondere das Flamm- und Plasmaspritzen mit den in DIN 32530 aufgeführten Varianten angewandt. Beim Flammspritzen wird das pulverförmige Material in einer Brenngas-Sauerstoffflamme an- oder aufgeschmolzen und durch das expandierende Verbrennungsgas allein oder mit gleichzeitiger Unterstützung durch ein Zerstäubungsgas (z.B. Druckluft) auf das Trägermaterial geschleudert. Dem Brenngas wird Sauerstoff in einer zur Verbrennung des Brenngases ausreichenden Menge zugeführt. Mit Acetylen als Brenngas wird eine Temperatur von maximal 3150° C erreicht. Wesentlich höhere Temperaturen von maximal 20000° C können beim Plasmaspritzen erreicht werden. Beim Plasmaspritzen wird das pulverförmige Material inner- oder außerhalb des Brenners durch eine Plasmaflamme an- oder aufgeschmolzen, beschleunigt und auf das Trägermaterial geschleudert. Das Plasma wird durch einen Lichtbogen, der zwischen Kathode und Anode brennt, erzeugt. Als Plasmagase werden z.B. Argon, Helium, Stickstoff oder deren Gemische verwendet. Der elektrisch neutrale Plasmastrahl verläßt mit hoher Geschwindigkeit und Temperatur den Plasmabrenner.

Das oxidkeramische Material mit einer Bruttzusammen setzung, die, gegebenenfalls mit Ausnahme des Sauerstoffgehalts, der eines Supraleiters entspricht, wird der Heizflamme pulverförmig innerhalb oder bevorzugt außerhalb des Brenners mittels eines Trägergases zugeführt. Das pulverförmige Material wird durch die hohen Temperaturen der Heizflamme geschmolzen oder an der Oberfläche der Pulverteilchen angeschmolzen. Das an- oder aufgeschmolzene Material wird als Spritzstrahl auf ein Trägermaterial gesprüht, auf dem es sich als Spritzschicht niederschlägt. Beim thermischen Spritzen verliert das oxidkeramische Material Sauerstoff, was den Verlust oder eine Verschlechterung der supraleitenden Eigenschaften zur Folge hat. Durch das erfindungsgemäße Verfahren wird das oxidkeramische Material im Spritzstrahl bis zum Auftreffen auf dem Trägermaterial wieder mit Sauerstoff angereichert, so daß eine Spritzschicht mit guten supraleitenden Eigenschaften erhalten wird.

Der Heizflamme und/oder dem Spritzstrahl wird der zusätzliche Sauerstoff, das Distickstoffoxid oder das Ozon vorzugsweise außerhalb des Brenners insbesondere am Brennerausgang, zugeführt. Man kann mit Sauerstoff angereicherte Luft verwenden; vorzugsweise wird jedoch reiner Sauerstoff zugeführt. Wird das pulverförmige Material außerhalb des Brenners in die Heizflamme gefördert, so kann der Sauerstoff, das Distickstoffoxid oder das Ozon an derselben Stelle wie das pulverförmige Material zugeführt werden. Es ist jedoch auch möglich, die Sauerstoff-, Distickstoffoxid- oder Ozonzuführung erst anschließend im Spritzstrahl vorzusehen.

Vorzugsweise sind mehrere Zuführungsleitungen oder Düsen um die Heizflamme oder den Spritzstrahl herum angeordnet. Die Zuführung wird vorzugsweise über eine um die Heiz flamme oder den Spritzstrahl angeordnete Ringdüse vorgenommen, um dem oxidkeramischen Material gleichmäßig von allen Seiten her Sauerstoff, Distickstoffoxid oder Ozon zuzuführen. Die Zuführungsleitungen oder Düsen sind vorzugsweise so angeordnet, daß der Sauerstoff, das Distickstoffoxid oder das Ozon senkrecht zur Strömungsrichtung des Spritzstrahls zugeführt wird. Bei einer anderen bevorzugten Ausführungsform werden Sauerstoff, Distickstoffoxid oder Ozon in einer mit der Strömungsrichtung des Spritzstrahls einen spitzen Winkel bildenden Strömung zugeführt. Um die Heizflamme und den Spritzstrahl mit dem zugeführten Sauerstoff, Distickstoffoxid oder Ozon zu umhüllen, kann nach dem Austritt des Sauerstoffs, Distickstoffoxids oder Ozons aus der oder den Zuführleitungen oder Düsen ein trichterförmiger Vorsatz um die Heizflamme und/oder den Spritzstrahl angeordnet sein. Z.B. kann an der Ringdüse ein trichterförmiger Vorsatz angeschraubt sein. Dadurch werden Heizflamme und Spritzstrahl durch den Sauerstoff, das Distickstoffoxid oder das Ozon umhüllt. Der Sauerstoff, das Distickstoffoxid oder das Ozon können auch zusammen mit dem pulverförmigen oxidkeramischen Material zugeführt werden, indem der Sauerstoff, das Distickstoffoxid oder das Ozon dem Trägergas zugesetzt werden, mit dem das Material in die Heizflamme des Brenners gefördert werden. Es ist auch möglich, als Trägergas ausschließlich Sauerstoff zu verwenden.

Besonders sauerstoffreiche Spritzschichten, d.h. besonders gute supraleitende Eigenschaften werden erhalten, wenn der Spritzabstand zwischen Brenner und Trägermaterial vergrößert wird. Allerdings kann wegen des mit zunehmenden Abstand sich vergrößernden Spritzverlustes kein zu großen Abstand gewählt werden. Daher wird innerhalb des Bereichs der üblicherweise verwendeten Spritzabstände ein möglichst großer Spritzabstand gewählt.

Das erfindungsgemäße Verfahren wird an Hand der Zeichnung und der Ausführungsbeispiele näher beschrieben. In der Zeichnung zeigt:

Fig. 1 einen schematischen Querschnitt durch eine erste Ausführungsform eines Plasmabrenners und den Weg des an- oder auf geschmolzenen Materials bis zum Auftreffen auf das Trägermaterial,

Fig. 2 einen schematischen Querschnitt durch eine zweite Ausführungsform eines Plasmabrenners und

Fig. 3 einen Schnitt entlang der Linie A - A durch den Plasmabrenner von Fig. 2.

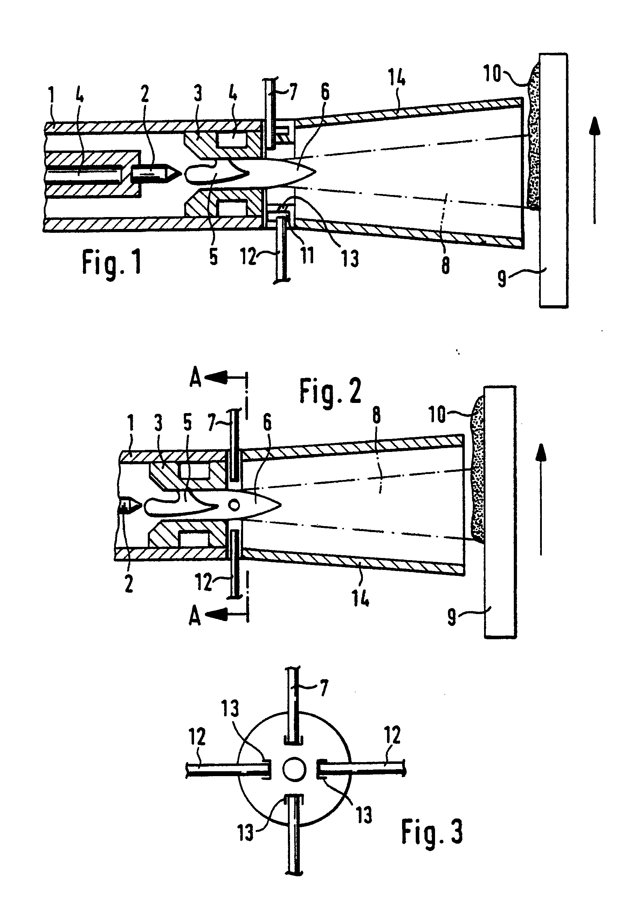

Innerhalb des Plasmabrenners 1 ist eine stabförmige Kathode 2 zentrisch angeordnet. Am Brennerausgang befindet sich eine ringförmige Anode 3. An der Kathode 2 und der Anode 3 sind Kühlwasserkanäle 4 vorgesehen. Zwischen Kathode 2 und Anode 3 brennt ein Lichtbogen hoher Energiedichte. Er gibt den größten Teil seiner Wärmeenergie an das Plasmagas 5 ab, das dadurch teilweise ionisiert wird. Zweiatomige Gase dissoziieren zunächst und geben die dabei aufgenommene Wärmeenergie außerhalb des Plasmabrenners 1 wieder ab. In die aus dem Brenner mit hoher Geschwindigkeit austretende Plasmaflamme 6 wird durch eine Pulverzuführung 7 am Brennerausgang das oxidkeramische Material geblasen. Das Material wird durch die hohe Temperatur der Plasmaflamme 6 an- oder aufgeschmolzen und mit dem Plasmagas als Spritzstrahl 8 auf das Trägermaterial 9 geschleudert, wo es sich als Spritzschicht 10 niederschlägt. Der Pfeil gibt die Vorschubrichtung des Trägermaterials 10 an. In Fig. 1 ist in Spritzrichtung gesehen, hinter der Pulverzuführung 7 eine Ringdüse 11 angeordnet, der durch die Leitung 12 Sauerstoff zugeführt wird. Die Düsenöffnung 13 ist zum Trägermaterial hin gerichtet, so daß der Sauerstoff in einer mit der Strömungsrichtung des Spritzstrahls 8 einen spitzen Winkel bildenden Strömung dem Spritzstrahl 8 und der Plasmaflammenspitze zugeführt wird. An den Brennerausgang schließt sich ein trichterförmiger Vorsatz 14 an, der um den Spritzstrahl 8 herum angeordnet ist.

In der Ausführungsform von Fig. 2 sind die Pulverzuführung 7 und die Sauerstoffzuführung auf der gleichen Höhe am Brennerausgang angeordnet. Der Sauerstoff wird durch drei Leitungen 12 zugeführt.

Diese Leitungen 12 sowie die Pulverzuführung 7 sind jeweils um 90° versetzt gegeneinander angeordnet (vgl. Fig. 3). Bei dieser Ausführungsform wird der Sauerstoff in einer jeweils senkrecht zur Strömungsrichtung des Spritzstrahls gerichteten Strömung der Plasmaflamme durch die Düsen 13 zugeführt.

Beispiel 1

Supraleitendes Pulver $Bi_2Sr_2CaCu_2O_{10-x}$ (Körnung unter 100 $\mu$m) wurde in eine Plasmaspritzanlage eingebracht, bei der um den Spritzstrahl herum drei Sauerstoffdüsen angeordnet waren, durch die reiner Sauerstoff senkrecht zur Strömungsrichtung des Spritzstrahls zugeführt wurde. (vgl. Fig. 2 und 3). Das an- bzw. aufgeschmolzene Material wurde auf eine Trägerplatte aus MgO mit einem Spritzabstand von 130 mm gespritzt. Die gebildete Spritzschicht hatte eine durch Elementaranalyse bestimmte Zusammensetzung von $Bi_2Sr_2CaCu_2O_{8,4}$ und eine Sprungtemperatur $T_c$ = 84 K (AC-Suszeptibilitätsmessung).

Vergleichsbeispiel

Beispiel 1 wurde identisch wiederholt mit der Ausnahme, daß kein Sauerstoff dem Spritzstrahl durch die Düsen zugeführt wurde. Die gebildete Spritzschicht hatte eine Zusammensetzung von $Bi_2Sr_2CaCu_2O_{7,8}$ und eine Sprungtemperatur $T_c$ = 80 K (AC-Suszeptibilitätsmessung).

Beispiel 2

In der Spritzanlage von Beispiel 1 wurde als supraleitendes Pulver $YBa_2Cu_3O_{7-x}$ (Körnung unter 100 $\mu$m) eingebracht, und dieses Material mit Sauerstoffzufuhr durch die Düsen auf eine Trägerplatte aus $ZrO_2$ mit einem Spritzabstand von 130 mm aufgebracht. Die gebildete Spritzschicht hatte eine Zusammensetzung von $YBa_2Cu_3O_{7,5}$ und eine Sprungtemperatur $T_c$ = 86 K.

Vergleichsbeispiel 2

Beispiel 2 wurde identisch wiederholt mit der Ausnahme, daß kein Sauerstoff dem Spritzstrahl durch die Düsen zugeführt wurde. Die gebildete Spritzschicht hatte eine Zusammensetzung von $YBa_2Cu_3O_{6,1}$ und war halbleitend.

Beispiel 3

In die Spritzanlage von Beispiel 1 wurde das supraleitende Material $Bi_2Sr_2CaCu_2O_x$ eingebracht, und dieses Material mit Sauerstoffzufuhr durch die Düsen auf eine Trägerplatte gespritzt, wobei unterschiedliche Spritzabstände verwendet wurden. Es wurden folgende Ergebnisse erhalten:

| Spritzabstand | Zusammensetzung der Spritzschicht | Sprungtemperatur $T_c$ |
|---|---|---|
| 100 mm | $Bi_2Sr_2CaCu_2O_{7,8}$ | 60 K |
| 120 mm | $Bi_2Sr_2CaCu_2O_{8,2}$ | 65 K |
| 130 mm | $Bi_2Sr_2CaCu_2O_{8,5}$ | 70 K |

Beispiel 4

Das in Beispiel 3 mit einem Spritzabstand von 120 mm erhaltene supraleitende Material wurde einer thermischen Nachbehandlung in Sauerstoffatmosphäre mit folgendem Temperaturprogramm unterzogen:

4

Das Material hatte nach der thermischen Nachbehandlung dieselbe Zusammensetzung wie vor der thermischen Nachbehandlung, nämlich $Bi_2Sr_2CaCu_2O_{8,2}$.

**Ansprüche**

1. Verfahren zum thermischen Spritzen von oxidkeramischen Materialien mit einer Bruttozusammensetzung, die, gegebenenfalls mit Ausnahme des Sauerstoffgehalts; der eines oxidkeramischen Supraleiters entspricht, bei dem man das pulverförmige Material in die Heizflamme des Brenners fördert, in der es an- bzw. aufgeschmolzen wird, und es als Spritzstrahl auf einem Trägermaterial auftreffen läßt, dadurch gekennzeichnet, daß man der Heizflamme und/oder dem Spritzstrahl zusätzlich Sauerstoff, Distickstoffoxid oder Ozon zuführt.

2. Verfahren nach Anspruch 1, dadurch gekennzeichnet, daß man am Brennerausgang Sauerstoff, Distickstoffoxid oder Ozon zuführt.

3. Verfahren nach Anspruch 1 oder 2, dadurch gekennzeichnet, daß man den Sauerstoff in Form einer mit Sauerstoff angereicherten Luft zuführt.

4. Verfahren nach Anspruch 1 oder 2, dadurch gekennzeichnet, daß man reinen Sauerstoff zuführt.

5. Verfahren nach einem der Ansprüche 1 bis 4, dadurch gekennzeichnet, daß man Sauerstoff, Distickstoffoxid oder Ozon an derselben Stelle wie das pulverförmige Material der Heizflamme zuführt.

6. Verfahren nach einem der Ansprüche 1 bis 5, dadurch gekennzeichnet, daß man Sauerstoff, Distickstoffoxid oder Ozon durch eine oder mehrere um die Heizflamme und/oder den Spritzstrahl herum angeordnete Zuführleitungen oder Düsen zuführt.

7. Verfahren nach einem der Ansprüche 1 bis 5, dadurch gekennzeichnet, daß man Sauerstoff, Distickstoffoxid oder Ozon durch eine um die Heizflamme und/oder den Spritzstrahl herum angeordnete Ringdüse zuführt.

8. Verfahren nach einem der Ansprüche 1 bis 7, dadurch gekennzeichnet, daß man Sauerstoff, Distickstoffoxid oder Ozon in einem senkrecht zur Strömungsrichtung des Spritzstrahls gerichteten Strömung der Heizflamme und/oder dem Spritzstrahl zuführt.

9. Verfahren nach einem der Ansprüche 1 bis 7, dadurch gekennzeichnet, daß man Sauerstoff, Distickstoffoxid oder Ozon in einer mit der Strömungsrichtung des Spritzstrahls einen spitzen Winkel bildenden Strömung der Heizflamme und/oder dem Spritzstrahl zuführt.

10. Verfahren nach Anspruch 9, dadurch gekennzeichnet, daß man Sauerstoff, Distickstoffoxid oder Ozon nach dem Austritt aus der oder den Zuführleitungen oder Düsen durch einen um die Heizflamme und/oder den Spritzstrahl angeordneten trichterförmigen Vorsatz strömen läßt.

11. Verfahren nach einem der Ansprüche 1 bis 10, dadurch gekennzeichnet, daß man Sauerstoff, Distickstoffoxid oder Ozon dem Trägergas zusetzt, das zur Förderung des pulverförmigen Materials in die Heizflamme des Brenners verwendet wird.

12. Verfahren nach einem der Ansprüche 1 bis 10, dadurch gekennzeichnet, daß man Sauerstoff als Trägergas zur Förderung des pulverförmigen Materials in die Heizflamme verwendet.

13. Verfahren nach einem der Ansprüche 1 bis 10, dadurch gekennzeichnet, daß das oxidkeramische Material Kupfer in oxidischer Form enthält.

14. Verfahren nach Anspruch 13, dadurch gekennzeichnet, daß das oxidkeramische Material Wismut oder Yttrium in oxidischer Form enthält.

15. Verfahren nach Anspruch 13, dadurch gekennzeichnet, daß das oxidkeramische Material Wismut, Strontium und Calcium in oxidischer Form enthält.

16. Verfahren nach einem der Ansprüche 1 bis 15, dadurch gekennzeichnet, daß das Flamm- oder Plasmaspritzen angewandt wird.

17. Verfahren nach einem der Ansprüche 1 bis 16, dadurch gekennzeichnet, daß ein möglichst großer Spritzabstand zwischen Brenner und Trägermaterial innerhalb des Bereichs der üblicherweise verwendeten Spritzabstände gewählt wird.

Fig. 1

Fig. 2

Fig. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 324 121  (NKK CORP.)<br>* Patentansprüche 1-3; Figur 2 * | 1,4,5,8,<br>11,12,13,<br>14,15,16 | C 23 C 4/10<br>H 01 L 39/24 |
| X | EP-A-0 302 506  (HITACHI)<br>* Patentanspruch 1; Figur 4C * | 1,3,4,5,<br>11,12,13,<br>14,16 | |
| X | EP-A-0 288 711  (IBM)<br>* Patentansprüche 1,14-16; Seite 9, Zeilen 7-14; Seite 5, Zeilen 11-18 * | 1,2,4,5,6,<br>7,9,10,11,<br>12,13,14,<br>16,17 | |
| X | EP-A-0 323 582  (ASEA BROWN BOVERI)<br>* Patentansprüche 1,3 * | 1,4,5,11,<br>12,13,14,<br>16 | |
| X | PATENT ABSTRACTS OF JAPAN, Band 13, Nr. 504 (C-653)[3852], 13. November 1989;<br>& JP-A-1 201 455 (NIPPON TELEGR. & TELEPH. CORP.) 14-08-1989<br>* Zusammenfassung * | 1,4,13,14,<br>16 | |
| X | PATENT ABSTRACTS OF JAPAN, Band 13, Nr. 447 (C-642)[3795], 6. Oktober 1989;<br>& JP-A-1 172 220 (TOKAI UNIV.) 07-07-1989<br>* Zusammenfassung * | 1,13,16 | **RECHERCHIERTE SACHGEBIETE (Int. Cl.5)**<br><br>C 23 C<br>H 01 L |
| X | THIN SOLID FILMS, Band 168, Nr. 2, 15. Januar 1989, Seiten 231-238, Lausanne, CH; L.S. WEN et al.: "Characterization of a plasma-sprayed YBaCuO superconductor"<br>* Seite 236, Zeilen 6-11 * | 1,13,14,<br>16 | |

−/−

Der vorliegende Recherchenbericht wurde für alle Patentansprüche erstellt

| Recherchenort | Abschlußdatum der Recherche | Prüfer |
|---|---|---|
| Den Haag | 12 November 90 | ELSEN D.B.A. |

Seite 2

**Europäisches Patentamt**

# EUROPÄISCHER RECHERCHENBERICHT

Nummer der Anmeldung

## EP 90 11 5548

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 13, Nr. 290 (C-614)[3638], 5. Juli 1989; & JP-A-1 83 651 (FUJITSU) 29-03-1989 * Zusammenfassung * | 1,4,11,13, 16 | |
| Y | EP-A-0 286 135   (SUMITOMO ELECTRIC INDUSTRIES) * Patentansprüche 1,11; Seite 5, Zeilen 7-20 * | 1,16 | |
| A | | 13,14,15 | |
| Y | DE-A-2 155 217   (PHILIPS PATENTVERWALTUNG) * Figur 1; Patentansprüche 1-4; Seite 6, Zeilen 1-5 * | 1,16 | |
| A | | 2-12 | |
| P,X | EP-A-0 330 196   (THE PERKIN-ELMER CORP.) * Figur 1; Patentansprüche 1-11 * | 1-14,16 | |
| P,X | PATENT ABSTRACTS OF JAPAN, Band 13, Nr. 546 (C-661)[3894], 6. Dezember 1989; & JP-A-1 224 206 (NATL. RES. INST. FOR METALS) 07-09-1989 * Zusammenfassung * | 1-12,16 | |

**RECHERCHIERTE SACHGEBIETE (Int. Cl.5)**

Der vorliegende Recherchenbericht wurde für alle Patentansprüche erstellt

| Recherchenort | Abschlußdatum der Recherche | Prüfer |
|---|---|---|
| Den Haag | 12 November 90 | ELSEN D.B.A. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument
----------------------------------------------------------
& : Mitglied der gleichen Patentfamilie, übereinstimmendes Dokument